# EUROPEAN PATENT APPLICATION

(11) **EP 4 679 491 A1**
(43) Date of publication of application: **14.01.2026**
(21) Application number: 24187045.0
(22) Date of filing: 08.07.2024
(51) Int. Cl.: H01L 21/20

(54) **METHOD FOR PRODUCING A GROWTH SUBSTRATE, METHOD FOR PRODUCING AN EPITAXIAL SILICON CARBIDE LAYER, GROWTH SUBSTRATE, AND EPITAXIAL SILICON CARBIDE LAYER**

(71) Applicant: Hitachi Energy Ltd, 8050 Zürich (CH)
(72) Inventor: Alfieri, Giovanni, 5103 Möriken (CH); Wehrle, Moritz, 8304 Wallisellen (CH); Wirths, Stephan, 8800 Thalwil (CH)
(74) Representative: Epping - Hermann - Fischer

(57) **Abstract**

A method for producing a growth substrate (1) for an epitaxial silicon carbide layer (5) is specified, the method comprising:
- providing an initial wafer (2), wherein the initial wafer (2) comprises silicon carbide and wherein the initial wafer (2) comprises a first dopant, and
- heating the initial wafer (2) to an annealing temperature within a first gas atmosphere, wherein the first dopant and the first gas comprise the same material element,
- such that a growth region (4) for the epitaxial silicon carbide layer (5) is produced, wherein a maximum concentration of the first dopant of the growth region (4) is higher than a maximum concentration of the first dopant in an initial wafer region.

Furthermore, a method for producing an epitaxial silicon carbide layer (5), a growth substrate (1), an epitaxial silicon carbide layer (5), and a power semiconductor device are provided.

## Description

The present disclosure relates to a method for producing a growth substrate, a method for producing an epitaxial silicon carbide layer, a growth substrate, and an epitaxial silicon carbide layer.

Typically, carbon vacancies in silicon carbide layers result in at least two electrically active levels in the bandgap, which are characteristic of recombination centers affecting lifetime and leakage currents in a typical semiconductor device.

Embodiments of the disclosure relate to a method for producing a growth substrate. Further embodiments relate to a method for producing an epitaxial silicon carbide layer, a growth substrate, and an epitaxial silicon carbide layer.

This is achieved by the subject-matter of the independent claims. Further embodiments are evident from the dependent claims and the following description.

A method for producing a growth substrate for an epitaxial silicon carbide layer is described. The growth substrate is particularly a growth substrate for the epitaxial silicon carbide layer. The epitaxial silicon carbide layer is in particular epitaxially growable on a top surface of the growth substrate.

According to an embodiment of the method for producing a growth substrate, an initial wafer is provided, wherein the initial wafer comprises silicon carbide, SiC, and wherein the initial wafer comprises a first dopant. The initial wafer exemplarily has a crystal structure, particularly comprising a layered structure. For example, the initial wafer is characteristic of a predetermined polytype of silicon carbide.

For example, the first dopant is incorporated in the silicon carbide in the crystal structure. Exemplarily, the initial wafer comprising the first dopant is of a first conductivity type. For example, the first conductivity type is an n-type. "N-type" means here and in the following that the first dopant is configured to add electrons to the silicon carbide.

Exemplarily, the first dopant is distributed in the initial wafer homogeneously. "Homogeneously" means here and in the following that a maximum concentration of the first dopant varies in the initial wafer by at most 10% or at most 5%.

According to the embodiment of the method for producing a growth substrate, the initial wafer is heated to an annealing temperature within a first gas atmosphere, wherein the first dopant and the first gas comprise the same material element. For example, the initial wafer is heated to the annealing temperature within the first gas atmosphere for a predetermined annealing time. During the predetermined annealing time, a top surface region of the initial wafer reacts, for example, with the first gas. Exemplarily, the reaction takes place up to a reaction depth, extending from a top surface to a bulk of the initial wafer.

Exemplarily, the element material accumulates up to the reaction depth in the top surface region. In particular, a concentration of the first dopant up to the first reaction depth is higher than in a bulk region of the initial wafer.

According to the embodiment of the method for producing a growth substrate, the initial wafer is heated to the annealing temperature within the first gas atmosphere such that a growth region for the epitaxial silicon carbide layer is produced, wherein a maximum concentration of the first dopant of the growth region is higher than a maximum concentration of the first dopant in the initial wafer region. After the annealing temperature and/or the first gas atmosphere are applied, the initial wafer is divided in two regions, namely the growth region and the initial wafer region. This means that by the heating and the application of the first gas atmosphere, the growth region is generated in the initial wafer up to the reaction depth. The initial wafer region is at least mostly not affected by the heating and the application of the first gas atmosphere in the sense that the initial wafer region has the same concentration of the first dopant as the initial wafer before the heating and the application.

For example, the maximum concentration of the first dopant is at least one order of magnitude higher than the maximum concentration of the first dopant in the initial wafer region.

Such a growth region particularly forms the top surface of the growth substrate. In particular, the epitaxial silicon carbide layer is epitaxially growable on the top surface formed of the growth region.

In summary, such a method advantageously produces a growth substrate for an epitaxial silicon carbide layer, wherein the epitaxial silicon carbide layer can be grown directly on the growth region. This makes the use of a typical buffer layer unnecessary.

Advantageously, a comparatively high concentration of the material element of the first dopant in the growth region leads to a strain in the crystal structure which, in turn, leads to the formation of interstitials, in particular interstitial carbon atoms. This means that such a growth region advantageously serves as a reservoir of interstitial carbon atoms during a growth of the epitaxial silicon carbide layer on the growth region, wherein a concentration of electrically active levels is advantageously reduced in such epitaxial silicon carbide layers grown on top of the growth region.

According to a further embodiment of the method for producing a growth substrate, a maximum concentration of interstitial carbon atoms in the growth region is higher than a maximum concentration of interstitial carbon atoms in the initial wafer region. Exemplarily, the maximum concentration of interstitial carbon atoms in the growth region is at least one order of magnitude higher than the maximum concentration of interstitial carbon atoms in the initial wafer region. The maximum concentration of interstitial carbon atoms in the growth region is at least 1·10¹¹ cm⁻³ and/or at most 1·10¹³ cm-3.

According to a further embodiment of the method for producing a growth substrate, a polymorph type of the silicon carbide is a hexagonal polytype 4H. In particular, the designation "4H" indicates that the hexagonal polytype has a hexagonal crystal structure. The hexagonal polytype 4H has, in particular, a periodicity of 4 in a stacking sequence along a c-axis of a hexagonal unit cell. This means that the silicon carbide having the hexagonal polytype 4H has a repeating sequence every four bilayers of silicon and carbon atoms.

According to a further embodiment of the method for producing a growth substrate, the first dopant and the first gas comprise nitrogen as the material element. In particular, the first dopant is nitrogen, N, and the first gas atmosphere is an N₂ atmosphere.

During the heating to the annealing temperature and the application of the first gas atmosphere an N-rich layer is produced in the initial wafer, being the growth region.

According to a further embodiment of the method for producing a growth substrate, a maximum concentration of the first dopant in the initial wafer region is at most 4·10¹⁸ cm⁻³. In particular, a maximum concentration of the first dopant in the initial wafer region is at least 1·10¹⁵ cm⁻³ and/or at most 1·10¹⁸ cm⁻³.

According to a further embodiment of the method for producing a growth substrate, a maximum concentration of the first dopant in the growth region is at least 5·10¹⁸ cm⁻³ and/or at most 5·10²⁰ cm⁻³.

Exemplarily, with such concentrations the first dopant, being particularly N in the N-rich layer, advantageously induces enough strain in the crystal structure in the growth region for forming the comparatively high maximum concentration of interstitial carbon atoms.

According to a further embodiment of the method for producing a growth substrate, the annealing temperature is at least 1000°C and/or at most 1500°C.

According to a further embodiment of the method for producing a growth substrate, the initial wafer is heated for a predetermined annealing time of at least 0.5 h and/or at most 5 h.

According to a further embodiment of the method for producing a growth substrate, the growth region has a thickness of at least 0.01 um and/or at most 1 um. Exemplarily, a thickness of the growth region is at least one order of magnitude higher than a thickness of the initial wafer region.

Advantageously, with the indicated annealing temperature and the indicated predetermined annealing time, the growth region is produced having a sufficient thickness and thus being particularly suitable for acting a as the reservoir for the interstitial carbon atoms.

A further embodiment relates to a method for producing an epitaxial silicon carbide layer, in particular comprising the growth substrate as produced by the method described herein before. Therefore, the features as described in connection with the method for producing a growth substrate are also applicable to the method for producing an epitaxial silicon carbide layer, and vice versa.

According to an embodiment of the method for producing an epitaxial silicon carbide layer, a growth substrate is provided comprising silicon carbide with a first dopant and comprising an initial wafer region and a growth region, wherein a maximum concentration of the first dopant in the growth region is higher than a maximum concentration of the first dopant in the initial wafer region.

According to the embodiment of the method for producing an epitaxial silicon carbide layer, the growth substrate is heated to a growth temperature. For example, the growth temperature is equal to the annealing temperature. Alternatively, the growth temperature is different from the annealing temperature, in particular the growth temperature is higher than the annealing temperature. Exemplarily, the growth temperature is at least 100°C or at least 2000°C higher than the annealing temperature.

According to the embodiment of the method for producing an epitaxial silicon carbide layer, the epitaxial silicon carbide layer is applied on the growth region. In particular, the epitaxial silicon carbide layer is applied to a top surface of the growth substrate being the top surface of the growth region. The epitaxial silicon carbide layer is in particular directly applied to the growth region.

Exemplarily, a plurality of epitaxial silicon carbide layers is applied to the growth region, accordingly. A polymorph type of the epitaxial silicon carbide layer is the hexagonal polytype 4H.

Advantageously, a further buffer layer can be omitted as the epitaxial silicon carbide layer can be directly grown on the growth region.

Exemplarily, when the epitaxial silicon carbide layer is grown on the growth region, the growth temperature leads to a diffusion of the interstitial carbon atoms from the growth region to the grown epitaxial silicon carbide layer, in particular during growth thereof. The diffused interstitial carbon atoms advantageously occupy native carbon vacancies. In this way, carbon vacancies are greatly reduced in the finished epitaxial silicon carbide layer.

According to a further embodiment of the method for producing an epitaxial silicon carbide layer, during heating and applying, the carbon in the growth region diffuses to the epitaxial silicon carbide layer, occupying carbon vacancies in the epitaxial silicon carbide layer. Particularly, during the heating and the application of the epitaxial silicon carbide layer, the interstitial carbon atoms of the growth region diffuse into the epitaxial silicon carbide layer.

According to a further embodiment of the method for producing an epitaxial silicon carbide layer, a maximum concentration of carbon vacancies in the produced epitaxial silicon carbide layer is less than 10¹⁰ cm⁻³. The provided value for the maximum concentration of carbon vacancies in the produced epitaxial silicon carbide layer is particularly a resolution limit of a corresponding measuring process.

According to a further embodiment of the method for producing an epitaxial silicon carbide layer, the growth temperature is at least 1300°C and at most 1500°C.

According to a further embodiment of the method for producing an epitaxial silicon carbide layer, the epitaxial silicon carbide layer and the growth substrate are produced in separate chambers.

According to a further embodiment of the method for producing an epitaxial silicon carbide layer, the epitaxial silicon carbide layer and the growth substrate are produced in the same chamber.

A further embodiment relates to a growth substrate for an epitaxial silicon carbide layer, which can be or is produced by the method described herein before. Therefore, the features as described in connection with the method for producing a growth substrate are also applicable to the growth substrate, and vice versa.

According to an embodiment, the growth substrate comprises an initial wafer region comprising silicon carbide with a first dopant.

According to the embodiment, the growth substrate comprises a growth region comprising silicon carbide with a first dopant.

According to the embodiment of the growth substrate, the growth region is located on the initial wafer region. In particular, the growth region and the initial wafer region each have a main extension plane in lateral directions. The growth region and the initial wafer region are stacked above one another in a vertical direction, perpendicular to the initial wafer region.

According to the embodiment of the growth substrate, a maximum concentration of the first dopant in the growth region is higher than a maximum concentration of the first dopant in the initial wafer region.

According to a further embodiment of the growth substrate, the initial wafer region and the growth region each comprise a first dopant.

According to a further embodiment of the growth substrate, a maximum concentration of interstitial carbon atoms in the growth region is higher than a maximum concentration of interstitial carbon atoms in the initial wafer region.

A further embodiment relates to an epitaxial silicon carbide layer, which can be or is produced by the method described herein before. Therefore, the features as described in connection with the method for producing an epitaxial silicon carbide layer are also applicable to the epitaxial silicon carbide layer, and vice versa.

According to an embodiment, the epitaxial silicon carbide layer comprises a growth substrate comprising silicon carbide with a first dopant and comprising an initial wafer region and a growth region.

According to the embodiment, the epitaxial silicon carbide layer comprises an epitaxial silicon carbide layer arranged on the growth region.

According to an embodiment of the epitaxial silicon carbide layer, a maximum concentration of the first dopant in the growth region is higher than a maximum concentration of the first dopant in the initial wafer region.

A further embodiment relates to a power semiconductor device, which comprises the epitaxial silicon carbide layer as described herein before. Therefore, the features as described in connection with the power semiconductor device are also applicable to the epitaxial silicon carbide layer, and vice versa.

The term "power" here and in the following, for example, refers to power semiconductor devices adapted for processing voltages and currents of more than 100 V, e.g. 650 V or 1200 V and/or more than 10 A.

The epitaxial silicon carbide layer of the power semiconductor device can be processed accordingly. The power semiconductor device is, for example, a power metal insulating semiconductor field-effect transistor, power MISFET for short. The term MISFET shall also comprise metal oxide semiconductor field-effect transistors, MOSFETs, which have an oxide as an insulating material at the gate. The power semiconductor device may also be an insulated-gate bipolar transistor, IGBT.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.
Figure 1 shows a flow chart of the method for producing a growth substrate for an epitaxial silicon carbide layer according to an exemplary embodiment.
Figure 2 shows a flow chart of the method for producing an epitaxial silicon carbide layer according to an exemplary embodiment.
Figures 3, 4 and 5 show method stages according to Figures 1 and 2, and in particular a growth substrate in Figure 3, and an epitaxial silicon carbide layer in Figure 4.
Figure 6 shows a deep-level transient spectroscopy measurement for an epitaxial silicon carbide layer according to an exemplary embodiment.
Figures 7 and 8 each show an I-V characteristic of a power semiconductor semiconductor device according to an exemplary embodiment.

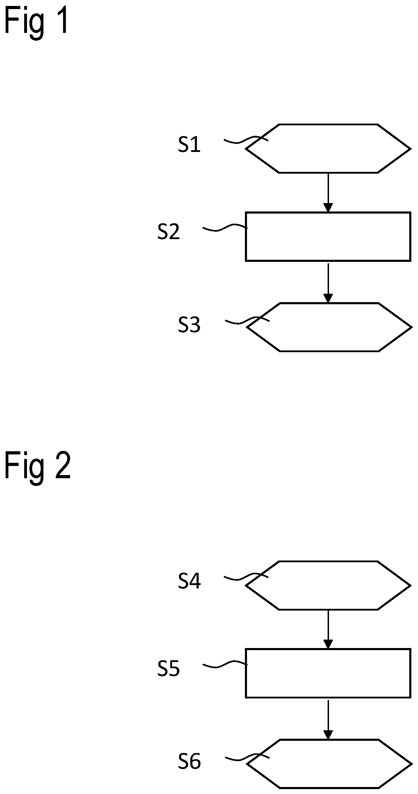

In method step S1 according to the exemplary embodiment of Figure 1 an initial wafer 2 is provided, wherein the initial wafer 2 comprises silicon carbide and wherein the initial wafer 2 comprises a first dopant. The initial wafer 2 particularly comprises silicon carbide of a hexagonal polytype 4H. The wafer is particularly provided in a chamber, which is equipped for example with a heater and a gas device configured for providing a gas atmosphere.

Subsequently, in method step S3, the initial wafer 2 is heated to an annealing temperature within a first gas atmosphere, wherein the first dopant and the first gas comprise the same material element. The initial wafer 2 is heated and is exposed to the first gas atmosphere for a predetermined annealing time. In particular, the first dopant is nitrogen, N, and the first gas atmosphere is an N₂ atmosphere. During the heating and the exposure to the first gas atmosphere, particularly nitrogen accumulates at a top surface region of the initial wafer 2.

After the heating and the exposure to the first gas atmosphere, in a method step S3, a growth region 4 for an epitaxial silicon carbide layer 5 is produced, wherein a maximum concentration of the first dopant of the growth region 4 is higher than a maximum concentration of the first dopant in an initial wafer region 3.

In particular, nitrogen accumulates at the top surface region up to a reaction depth, extending from a top surface of the initial wafer 2 towards a bulk of the initial wafer 2. The region where the nitrogen accumulates is formed to the growth region 4, where the maximum concentration of the first dopant is higher, particularly by at least one order of magnitude higher, than the maximum concentration of the first dopant in the initial wafer 2. The rest of the initial wafer 2 is formed to the initial wafer region 3, where the maximum concentration of the first dopant is smaller, particularly by at least one order of magnitude smaller, than the maximum concentration of the first dopant in the growth region 4.

The produced growth substrate 1 comprises the growth region 4 and the initial wafer region 3, particularly for an epitaxial silicon carbide layer 5. The growth region 4 is configured to be the region on which the epitaxial silicon carbide layer 5 is grown directly.

In method step S4 according to the exemplary embodiment of Figure 2, a growth substrate 1 comprising silicon carbide with a first dopant and comprising an initial wafer region 3 and a growth region 4 is provided. The growth substrate 1 is particularly the growth substrate 1 as produced in connection with Figure 1. The wafer is particularly provided in a chamber, which can be a different chamber than according to the method of Figure 1, which is equipped with a further heater and an epitaxial evaporation device, for example.

Therefore, the maximum concentration of the first dopant in the growth region 4 is higher than the maximum concentration of the first dopant in the initial wafer region 3. The maximum concentration of the material element of the first dopant in the growth region 4 leads to a strain in a crystal structure of the silicon carbide, which leads to a formation of interstitial carbon atoms. In particular, a maximum concentration of interstitial carbon atoms in the growth region 4 is at least 1·10¹¹ cm⁻³ and/or at most 1·10¹³ cm⁻³.

The growth substrate 1 is heated to a growth temperature in method step S5. The growth temperature is, for example, higher than the annealing temperature according to the method of Figure 1.

During the heating to the growth temperature, the epitaxial silicon carbide layer 5 is applied on the growth region 4.

When the epitaxial silicon carbide layer 5 is applied, in particular is grown, on the growth region 4, the growth temperature leads to a diffusion of the interstitial carbon atoms from the growth region 4 to the epitaxial silicon carbide layer 5, in particular during an application, particular during a growth, thereof. The diffused interstitial carbon atoms occupy native carbon vacancies in the epitaxial silicon carbide layer 5. In this way, carbon vacancies are greatly reduced in the finished epitaxial silicon carbide layer 5. A maximum concentration of carbon vacancies in the produced epitaxial silicon carbide layer 5 is less than 10¹⁰ cm⁻³.

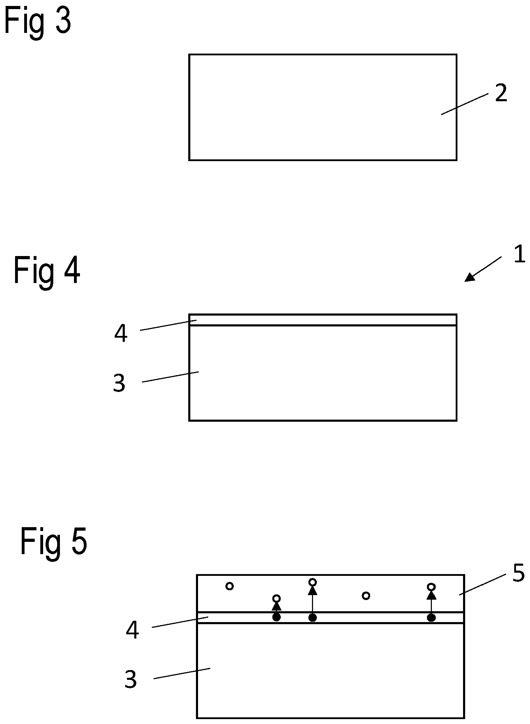

Figures 3 and 4 correspond to the method steps of Figure 1, particularly to method steps S1 and S2, respectively. The initial wafer 2 according to Figure 3 is formed of silicon carbide, which is doped with a first dopant. The initial wafer 2 has a main extension direction, wherein a top surface is formed of a main surface extending along the main extension direction.

The growth substrate 1 according to Figure 4 comprises an initial wafer region 3 and a growth region 4, which are stacked above one another perpendicular to the main extension direction. A stacking direction is defined as a vertical direction. A height of the growth region 4 in the vertical direction is smaller, particularly at least one order of magnitude smaller, than a height of the initial wafer region 3 in the vertical direction.

Figure 5 corresponds to the method steps of Figure 2, wherein the epitaxial silicon carbide layer 5 is applied on the growth region 4. Interstitial carbon atoms in the growth region 4 are indicated as black dots. Carbon vacancies in the epitaxial silicon carbide layer 5 are indicated as black circles. During heating to the growth temperature and during the application of the epitaxial silicon carbide layer 5, the interstitial carbon atoms of the growth region 4 diffuse to the carbon vacancies in the epitaxial silicon carbide layer 5 and occupy them, as indicated by arrows.

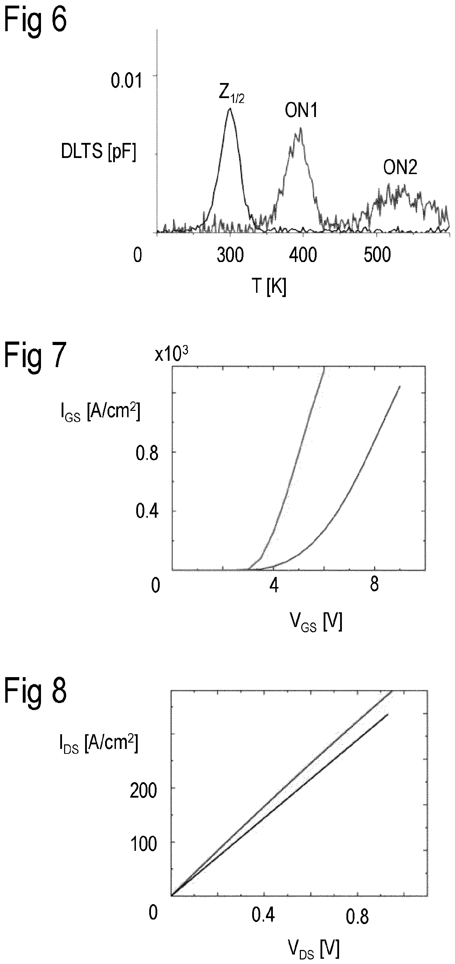

In the diagram of Figure 6, deep-level transient spectroscopy, DLTS, values in pF are indicated on the y-axis and a corresponding measurement temperature is indicated on the x-axis. A measurement curve comprising a Z_{1/2} peak is characteristic of a typical grown epitaxial silicon carbide layer. A measurement curve comprising an ON1 and an ON2 peak is characteristic of a grown epitaxial silicon carbide layer 5 according to an exemplary embodiment, i.e. being grown on the growth region 4. Exemplarily, the Z_{1/2} peak is characteristic of the presence of carbon vacancies in the epitaxial silicon carbide layer, wherein the ON1 and the ON2 peak is characteristic of no presence of carbon vacancies in the epitaxial silicon carbide layer 5. In particular, the ON1 and the ON2 peak relate to two electrically active levels which are known to be related to carbon.

The use of the epitaxial silicon carbide layer 5 described herein before, particularly in connection with Figure 5 can be employed for a power semiconductor device, such as a MOSFET, in particular a 4H-SiC MOSFET. The reduction of carbon vacancies in the epitaxial silicon carbide layer 5 advantageously leads to a decrease in an on-resistance, R_{ON}, and to an improvement of the electrical characteristics of the power semiconductor device as shown in Figures 7 and 8.

In the diagram of Figure 7, a gate source current, I_{GS}, given in A/cm² is indicated on the y-axis and a corresponding gate source voltage, V_{GS}, given in V is indicated on the x-axis. The two curves are characteristic of a drain source voltage of 10 V at a temperature of 25°C.

In the diagram of Figure 8, a drain source current, I_{DS}, given in A/cm² is indicated on the y-axis and a corresponding drain source voltage, V_{DS}, given in V is indicated on the x-axis. The two curves are characteristic of a gate source voltage of 15 V at a temperature of 25°C.

In both Figures 7 and 8, the upper curves are characteristic of the epitaxial silicon carbide layer 5 which is grown on the growth region 4 as described herein above. In contrast, the lower curves are characteristic of typical epitaxial silicon carbide layers 5 which are not grown on the growth region 4.

The exemplary embodiments, in particular features of the exemplary embodiments, of the Figures can be combined with one another.

### Reference Signs

- 1: growth substrate
- 2: initial wafer
- 3: initial wafer region
- 4: growth region
- 5: epitaxial silicon carbide layer

- S1..S5: method steps

## Claims

1. Method for producing a growth substrate (1) for an epitaxial silicon carbide layer (5), comprising:
- providing an initial wafer (2), wherein the initial wafer (2) comprises silicon carbide and wherein the initial wafer (2) comprises a first dopant, and
- heating the initial wafer (2) to an annealing temperature within a first gas atmosphere, wherein the first dopant and the first gas comprise the same material element,
- such that a growth region (4) for the epitaxial silicon carbide layer (5) is produced, wherein a maximum concentration of the first dopant of the growth region (4) is higher than a maximum concentration of the first dopant in an initial wafer region (3).

2. Method according to claim 1, wherein
- a maximum concentration of interstitial carbon atoms in the growth region (4) is higher than a maximum concentration of interstitial carbon atoms in the initial wafer region (3).

3. Method according to one of claims 1 or 2, wherein
- a polymorph type of the silicon carbide is a hexagonal polytype 4H, and/or
- the first dopant and the first gas comprise nitrogen as the material element.

4. Method according to one of claims 1 to 3, wherein
- a maximum concentration of the first dopant in the initial wafer region (3) is at most 4·10¹⁸ cm⁻³, and/or
- a maximum concentration of the first dopant in the growth region (4) is at least 5·10¹⁸ cm⁻³ and/or at most 5·10²⁰ cm⁻³.

5. Method according to one of claims 1 to 4, wherein
- the annealing temperature is at least 1000°C and/or at most 1500°C, and/or
- the initial wafer (2) is heated for a predetermined annealing time of at least 0.5 h and/or at most 5 h.

6. Method according to one of claims 1 to 5, wherein
- the growth region (4) has a thickness of at least 0.01 um and/or at most 1 um.

7. Method for producing an epitaxial silicon carbide layer (5), comprising:
- providing a growth substrate (1) comprising silicon carbide with a first dopant and comprising an initial wafer region (3) and a growth region (4), wherein a maximum concentration of the first dopant in the growth region (4) is higher than a maximum concentration of the first dopant in the initial wafer region (3),
- heating the growth substrate (1) to a growth temperature, and
- applying the epitaxial silicon carbide layer (5) on the growth region (4).

8. Method according to claim 7, wherein
- during heating and applying, the carbon in the growth region (4) diffuses to the epitaxial silicon carbide layer (5), occupying carbon vacancies in the epitaxial silicon carbide layer (5).

9. Method according to one of claims 7 or 8, wherein
- a maximum concentration of carbon vacancies in the produced epitaxial silicon carbide layer (5) is less than 10¹⁰ cm⁻³.

10. Method according to one of claims 7 to 9, wherein
- the growth temperature is at least 1300°C and at most 1500°C.

11. Method according to one of claims 7 to 10, wherein
- the epitaxial silicon carbide layer (5) and the growth substrate (1) are produced in separate chambers, or
- the epitaxial silicon carbide layer (5) and the growth substrate (1) are produced in the same chamber.

12. Growth substrate (1) for an epitaxial silicon carbide layer (5), comprising
- an initial wafer region (3) comprising silicon carbide with a first dopant, and
- a growth region (4) comprising silicon carbide with a first dopant, wherein
- the growth region (4) is located on the initial wafer region (3), and
- a maximum concentration of the first dopant in the growth region (4) is higher than a maximum concentration of the first dopant in the initial wafer region (3).

13. Growth substrate (1) according to claim 12, wherein
- the initial wafer region (3) and the growth region (4) each comprise a first dopant, and
- a maximum concentration of interstitial carbon atoms in the growth region (4) is higher than a maximum concentration of interstitial carbon atoms in the initial wafer region (3).

14. Epitaxial silicon carbide layer (5), comprising
- a growth substrate (1) comprising silicon carbide with a first dopant and comprising an initial wafer region (3) and a growth region (4), and
- an epitaxial silicon carbide layer (5) arranged on the growth region (4), wherein
- a maximum concentration of the first dopant in the growth region (4) is higher than a maximum concentration of the first dopant in the initial wafer region (3).

15. Power semiconductor device, comprising
- an epitaxial silicon carbide layer (5) according to claim 14.
